# EUROPÄISCHE PATENTSCHRIFT

(11) **EP 2 268 569 B1**
(45) Veröffentlichungstag und Bekanntmachung des Hinweises auf die Patenterteilung: **11.12.2019**
(21) Anmeldenummer: 08802798.2
(22) Anmeldetag: 06.10.2008
(51) Int. Cl.: B81C 1/00

(54) **NANO-IMPRINTSTEMPEL**
NANO-IMPRINT STAMP
TAMPON D'IMPRESSION NANOMÉTRIQUE

(30) Priorität: 05.10.2007 DE 102007047598
(43) Veröffentlichungstag der Anmeldung: 05.01.2011
(73) Patentinhaber: Opsolution Nanophotonics GmbH, 34119 Kassel (DE)
(72) Erfinder: HILLMER, Hartmut, 34121 Kassel (DE)
(74) Vertreter: Beck & Rössig European Patent Attorneys
(86) Internationale Anmeldenummer: PCT/EP2008/008427
(87) Internationale Veröffentlichungsnummer: WO 2009/046954

(56) Entgegenhaltungen:
- EP-A- 1 387 216
- JP-A- 3 100 942
- US-A- 4 723 903

## Beschreibung

Die Erfindung richtet sich auf einen Nano-Imprintstempel gemäß dem Oberbegriff von Patentanspruch 1.

Aus US-A-4723903 ist ein Nano-Imprintstempel bekannt, mit einem Stempelkorpus der durch lokalen Materialabtrag aus einem Stempelrohling gefertigt ist und eine Stempelstirnstruktur bildet, wobei diese Stempelstirnstruktur in Richtung einer Stempelsetzachse in ein Umformsubstrat einpressbar ist, zur Generierung eines zur Stempelstimstruktur komplementären Abdrucks, wobei die Stempelstirnstruktur mehrere Setzflächen trägt die im wesentlichen quer zur Stempelsetzachse ausgerichtet sind, und diese SeLzflächen in Richtung der Stempelsetzachse betrachtet unterschiedliche vertikale Levelpositionen einnehmen, wobei der Stempelrohling als Schichtstruktur aufgebaut ist, und mehrere beinhaltet, wobei die Schichtstruktur derart gestaltet ist, dass die Positionen der Schichtgrenzen den vertikalen Levelpositionen der Setzflächen entsprechen. Bei diesem bekannten Mehrschichtstempel sind die Schichten aus unterschiedlichen Materialien hergestellt.

Bislang bekannte Nano-Imprintstempel sind derart ausgebildet, dass diese eine Stirnflächenstruktur aufweisen die Erhebungen und Senkungen bildet. Die Erhebungen bilden hierbei Plateauflächen. Die Plateauflächen verlaufen in einer Stempelfrontebene. Die zwischen den Plateauflächen verlaufenden Senkungen sind typischerweise so gestaltet, dass die Bodenflächen derselben gleiche Abstände zur vorgenannten Stempelfrontebene aufweisen.

Der Erfindung liegt die Aufgabe zugrunde, Lösungen aufzuzeigen durch welche es möglich wird, Nano-Imprintstempel zu fertigen die als solche besondere geometrische Eigenschaften aufweisen und hierdurch weitere Gestaltungsmöglichkeiten für Nano-Imprint Produkte bieten.

Diese Aufgabe wird erfindungsgemäß durch einen Nano-Imprintstempel mit den in Patentanspruch 1 angegebenen Merkmalen gelöst.

### Kurze Beschreibung der Figuren

Weitere Einzelheiten und Merkmale der Erfindung ergeben sich aus der nachfolgenden Beschreibung in Verbindung mit der Zeichnung. Es zeigt:
- **Fig. 1a**: perspektivische Darstellung zur Veranschaulichung eines aus einer Schichtstruktur gebildeten Nano-Imprintstepels mit mehreren Setzflächen, wobei die Schichtstruktur derart gestaltet ist, dass der Verlauf der Schichten im wesentlichen mit dem Verlauf für die Ausbildung der Setzflächen relevanten Levelpositionen korrespondiert;
- **Fig. 1b**: eine Schemadarstellung zur Veranschaulichung der Vorgehensweise wie mit 2 Masken bereits 2²= 4 verschiedene Stufen realisiert werden können, wobei die hierbei erreichten Stufenflächen sich entlang der Schichtgrenzen erstrecken;
- **Fig. 2**: eine Schemadarstellung zur Veranschaulichung der Bewerkstelligung des Materialabtrags durch Trockenätzen und nasschemisches Ätzen, wobei die Herantastung an die Schichtgrenzen im Wege des nasschemischen Materialabtrags erfolgt;
- **Fig. 3**: (a) einen eine Stufentektur bildenden Stempel, (b) ein durch einen Rohling mit geringer Schichtendicke gefertigtes quasikontinuierliches Stempelprofil;
- **Fig. 4**: eine Konzeptdarstellung zur Veranschaulichung wie die individuellen Schichtdicken im Zusammenspiel mit den gepunktet dargestellten Grenzflächen unterschiedliche Stufenhöhen erzeugen. Die Stufenlängen, bzw, Grubenbreiten werden durch die Photomasken festgelegt;
- **Fig. 5**: eine Konzeptdarstellung zur Veranschaulichung wie zwei verschiedene Materialsysteme A und B abwechselnd aufeinander liegen. Alle Schichten A und alle Schichten B sind dabei untereinander gleich dick. In diesem Beispiel beginnt die Struktur oben mit A und endet mit B. Es ist selbstverständlich auch denkbar mit B zu beginnen und mit B zu enden, oder mit A zu beginnen und mit A zu enden, oder mit A zu beginnen und mit B zu enden u.s.w.
- **Fig. 6**: eine Konzeptdarstellung zur Veranschaulichung wie zwei verschiedene Materialsysteme A und B abwechselnd aufeinander liegen. Alle Schichtdicken A sind hierbei beliebig, während jedoch alle Schichten B identische Dicke aufweisen. In diesem Beispiel beginnt die Struktur oben mit A und endet mit B. Es ist selbstverständlich auch denkbar mit B zu beginnen und mit B zu enden, oder mit A zu beginnen und mit A zu enden, oder mit A zu beginnen und mit B zu enden u.s.w.
- **Fig. 7**: eine Konzeptdarstellung zur Veranschaulichung wie zwei verschiedene Materialsysteme A und B abwechselnd aufeinander liegen. Alle Schichtdicken sind hierbei beliebig.
- **Fig. 8**: eine Konzeptdarstellung zur Veranschaulichung wie drei verschiedene Materialsysteme A, B und C abwechselnd aufeinander liegen. Alle Schichtdicken sind hierbei beliebig. Hierbei ist die Reihenfolge A/B/C/A/B/C/A...
- **Fig. 9**: eine Konzeptdarstellung zur Veranschaulichung wie drei verschiedene Materialsysteme A, B und C abwechselnd aufeinander liegen. Alle Schichtdicken und die Reihenfolge sind hierbei beliebig. Es treten sinnvollerweise jedoch keine Grenzflächen A/A, B/B und C/C auf.
- **Fig. 10**: vier Gruben und insgesamt 4+1 verschiedene Level. Dieses Resultat kann z.B. mit dem in Fig. 2 als auch mit dem in Fig. 14 beschriebenen Verfahren realisiert werden.
- **Fig. 11**: vier Gruben und insgesamt 4+1 verschiedene Level. Dieses Resultat kann z.B. mit dem in Fig. 14 als auch mit dem im Ausführungsbeispiel X beschriebenen Verfahren realisiert werden.
- **Fig. 12**: korrespondiert zu Fig. 11 bis auf die Tatsache dass bei Bedarf auch eine Luft/B Grenzfläche realisiert werden kann.
- **Fig. 13.**: schematisch einen Stempel, der auf der Basis von drei verschiedenen Materialsystemen realisiert wurde.
- **Fig. 14**: ein Ausführungsbeispiel mit mehreren aus zwei verschiedenen Materialien gefertigten Schichten und durch nasschemische Abtragung gebildeten Senkungen;
- **Fig.15**: ein Ausführungsbeispiel mit mehreren, aus zwei verschiedenen Materialien gefertigten Schichten und durch kombiniertes trocken- und nasschemische Abtragung gebildeten Senkungen;
- **Fig. 16a,b**: zwei Oberflächenrauhigkeitsmessungen auf dem Grubenboden an einer trockengeätzten Luft/GaAs Grenzfläche mit einem Weisslichtinterferometer. Die Oberflächenrauhigkeiten liegen dabei in der Größenordnung von ca. 1.5nm.
- **Fig. 17**: Oberflächenrauhigkeitsmessungen auf dem Grubenboden an einer selektiv nass-chemisch geätzten GaInAs/InP Grenzfläche mit einem Weisslichtinterferometer. Die Oberflächenrauhigkeiten liegen dabei in der Größenordnung von ca. 0.15nm. Dieses Bild zeigt die Leistungsfähigkeit des beschriebenen Verfahrens
- **Fig. 18**: eine Lichtmikroskopische Aufnahme eines Stempels, mit 8x8=64 verschiedenen Grubentiefen. Selbstverständlich können die Stempel lateral beliebige Muster aufweisen. Diese Abbildung ist lediglich als Beispiel zu verstehen. Eine derartige Anordnung wäre z.B. für das in [9-11] veranschaulichte Sensorarray verwendbar.
- **Fig. 19**: eine Messung eines Stempel-Ausschnittes mit einem Weisslichtinterferometer, wobei die zwei Gruben unterschiedliche Tiefen aufweisen. Die Tiefe ist dabei in verschiedene Graustufen umgesetzt.
- **Fig. 20**: eine Messung mit einem Oberflächenprofilometer an zwei verschiedenen Gruben.
- **Fig. 21**: schematisch einen Querschnitt durch einen Ausschnitt eines abstimmbaren Sensorarrays. Zu sehen sind 3 Pixel
- **Fig. 22**: eine Konzeptdarstellung zur Veranschaulichung wie auf der Basis eines Materials z.B. AlₓGa₁₋ₓAs oder Ga_{y}In_{1-y}As Kompositionsverläufe (Legierungsverläufe) durch Variation der Kompositionsparameter x oder y realisiert werden können, um abrupte Grenzflächen zu erzeugen, welche jeweils einen Ätzstop beim nass-chemischen Ätzen bewirken können.
- **Fig. 23**: Entsprechendes ist auch für einen Dotierungsverlauf innerhalb eines Materials wie z.B. GaAs möglich. In der Abbildung ändert sich die Dotierungskonzentration in vertikaler Richtung immer wieder zwischen einer niedrigen und einer hohen Dotierungskonzentration, wobei abrupte Wechsel erzielt werden (Grenzflächen), welche jeweils einen Ätzstop beim nass-chemischen Ätzen bewirken können.
- **Fig. 24**: Entsprechendes ist auch für einen Dotierungsverlauf innerhalb eines Materials wie z.B. GaAs möglich. In der Abbildung ändert sich die Dotierungskonzentration in vertikaler Richtung (z-Richtung) immer wieder zwischen einer niedrigen und einer hohen Dotierungskonzentration, wobei abrupte Wechsel erzielt werden (Grenzflächen), welche jeweils einen Ätzstop beim nass-chemischen Ätzen bewirken können.
- **Fig. 25 (a)**: vor Anwendung einer lokalen Deposition (b) nach Ausführung der lokalen Deposition. Die Deposition erfolgt dabei bevorzugt mit einem maskenlosen Verfahren (z.B. Focussed Ion Beam). Auch hierbei ist eine Definition von Levelhöhen außerhalb des durch die Position der Heterogrenzflächen vorgegebenen Levelhöhen möglich oder eine Nachkorrektur von einzelnen Levelhöhen.
- **Fig. 26**: (a) eine Teilmaskierung mit einer Abdeckschicht AS. In (b) wurde den nicht abgedeckten Stempelbereichen mit Hilfe eines Trockenätzschrittes die Levelhöhe verringert. Dies kann unter anderem folgenden Hintergrund haben: es ist eine Definition von Levelhöhen außerhalb des durch die Position der Heterogrenzflächen vorgegebenen Levelhöhen möglich oder eine Nachkorrektur von einzelnen Levelhöhen. Entsprechend kann (hier nicht dargestellt) auch eine Deposition erfolgen, wobei sich dann die Levelhöhe erhöht. Der Hintergrund dieser Maßnahme entspricht dabei dem von Fig. 26.
- **Fig. 27**: (a) vor Anwendung eines lokalen Ätzens (b) nach Ausführung der Ätzung. Die Ätzung erfolgt dabei bevorzugt mit einem maskenlosen Verfahren (z.B. Focussed Ion Beam). Auch hierbei ist eine Definition von Levelhöhen außerhalb der durch die Position der Heterogrenzflächen vorgegebenen Levelhöhen möglich oder eine Nachkorrektur von einzelnen Levelhöhen.

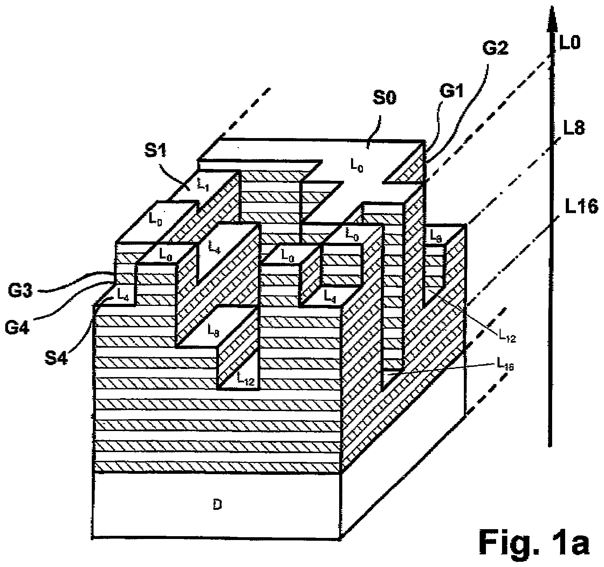

Figur 1a zeigt einen erfindungsgemäßen Nano-Imprint Stempel mit einem Stempelkorpus (K) der durch lokalen Materialabtrag aus einem Stempelrohling gefertigt ist und eine Stempelstimstruktur bildet, wobei diese Stempelstirnstruktur in Richtung einer Stempelsetzachse (X) in ein Umformsubstrat einpressbar ist, zur Generierung eines zur Stempelstimstruktur komplementären Abdrucks.

Die Stempelstirnstruktur trägt mehrere Setzflächen (S1,S2,...) die im wesentlichen quer zur Stempelsetzachse (X) ausgerichtet sind, wobei diese Setzflächen (S1,S2,...) in Richtung der Stempelsetzachse (X) betrachtet unterschiedliche Levelpositionen (L1, L2...) einnehmen.

Der Nano-Imprintstempel zeichnet sich dadurch aus, dass der Stempelrohling als Schichtstruktur aufgebaut ist, und mehrere Schichtgrenzen (G1, G2, G3) beinhaltet, wobei die Schichtstruktur derart gestaltet ist, dass die Positionen der Schichtgrenzen (G1, G2, G3) den Levelpositionen (L1, L2...) entsprechen.

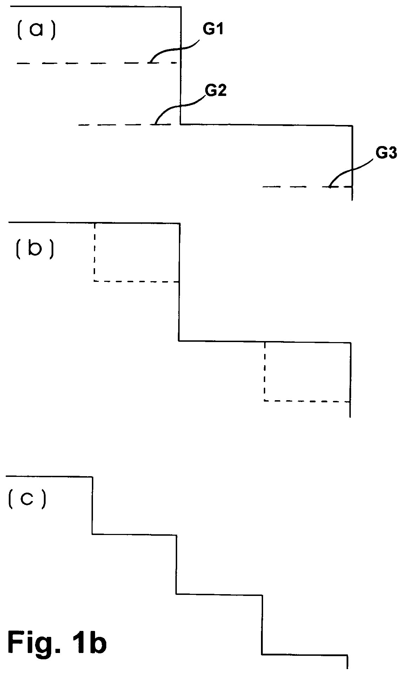

Wie aus der Darstellung nach Figur 1b ersichtlich ist es möglich, unter Verwendung von zwei Masken 22, d.h. 4 verschiedene Stufen zu fertigen, wobei die hierbei erreichten Stufenflächen sich entlang der Schichtgrenzen (G1, G2, G3) eines entsprechenden Stempelrohlings erstrecken.

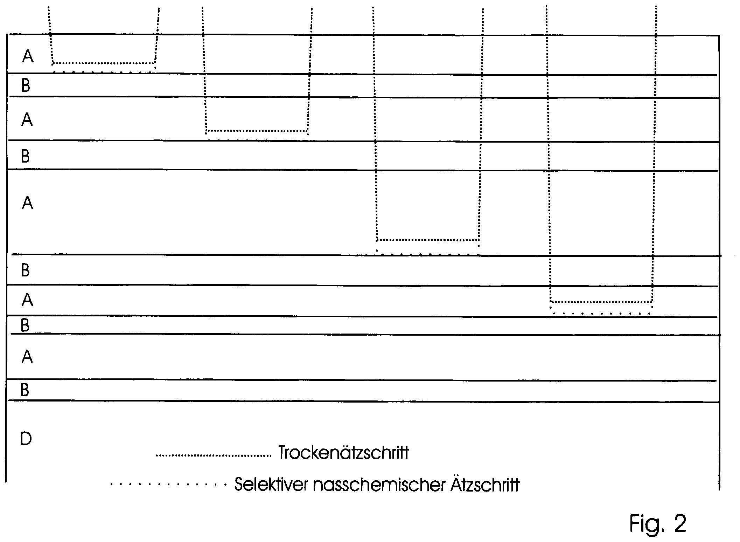

Bei dem Beispiel nach Figur 2 sind fünf Schichten A und fünf Schichten B vorgesehen. Es wird ein nass-chemischer Ätzprozess verwendet, welcher A selektiv gegenüber B ätzt. Weiterhin wird ein Trockenätzprozess durchgeführt, welcher sowohl die Schichen A als auch die Schichten B zu ätzen vermag. Durch diesen Prozess kann in einem Stück bis kurz vor die gewünschte Grenzfläche mit dem Trockenätzen vorgedrungen werden. Der nachfolgende nass-chemische Schritt legt schließlich die Grenzfläche frei. In diesem Beispiel können somit 5-7 verschiedene Level erzeugt werden. Je nachdem ob die Grenzflächen Luft/A und B/D mitgenutzt werden. Bei einem derartigen Verfahren können mit M Schritten (2^{M}+1) verschiedene Level erzeugt werden.
1. Schritt: Um die oberflächennächste Grenzfläche A/B in einer Ätzgrube freizulegen wird Photolack aufgebracht, dieser partiell mit einer Photomaske belichtet und entwickelt. Dabei ist die Maske/Fotolackart so gewählt, dass das Material A an den Stellen, an denen die Grube zu ätzen ist, freigelegt wurde. Es wird nun zuerst ein Trockenätzschritt (gepunktet) und danach der selektive nasschemische Ätzschritt (gestrichelt) durchgeführt, welche das Material A ätzt, das Material B jedoch nicht.
2. Schritt: Um die nächstfolgende Grenzfläche A/B in allen oder einem Teil der bereits geätzten Gruben freizulegen wird wieder Photolack aufgebracht, dieser partiell mit einer Photomaske belichtet und entwickelt. Dabei ist die Maske/Fotolackart so gewählt, dass das Material B an den Stellen, an denen die Grube zu ätzen ist, freigelegt wurde. Es wird nun wieder zuerst ein Trockenätzschritt (gepunktet) und danach der selektive nasschemische Ätzschritt (gestrichelt) durchgeführt, welche das Material A ätzt, das Material B jedoch nicht.
3. u.s.w.

In diesem Verfahren wird jedoch nur jede zweite Grenzfläche genutzt. Dafür wird aber auch nur ein trocken- und ein nass-chemisches Ätzverfahren eingesetzt. Im folgenden wird beschrieben, wie jede Grenzfläche genutzt werden kann.

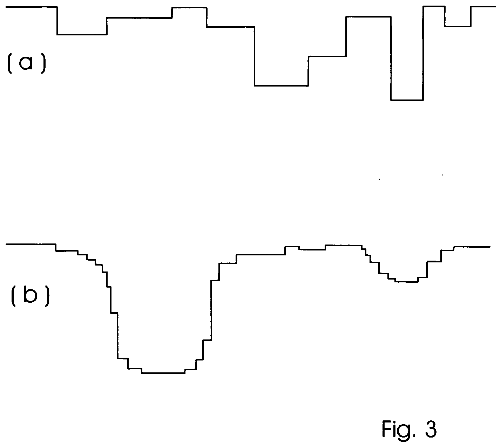

Figur 3 veranschaulicht durch die obere Darstellung (a) einen eine Stufentektur bildenden Stempel. Die untere Darstellung (b) zeigt ein durch einen Rohling mit geringer Schichtendicke gefertigtes quasikontinuierliches Stempelprofil.

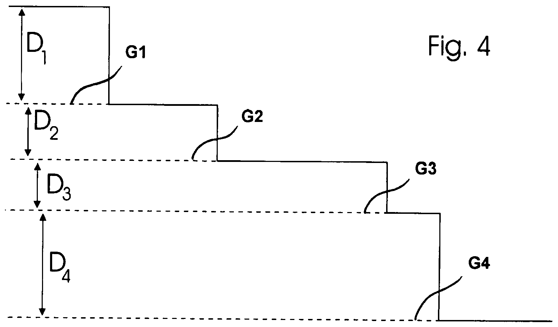

Figur 4 zeigt eine Konzeptdarstellung zur Veranschaulichung wie die individuellen Schichtdicken im Zusammenspiel mit den gepunktet dargestellten Grenzflächen unterschiedliche Stufenhöhen erzeugen. Die Stufenlängen, bzw, Grubenbreiten werden durch die Photomasken festgelegt.

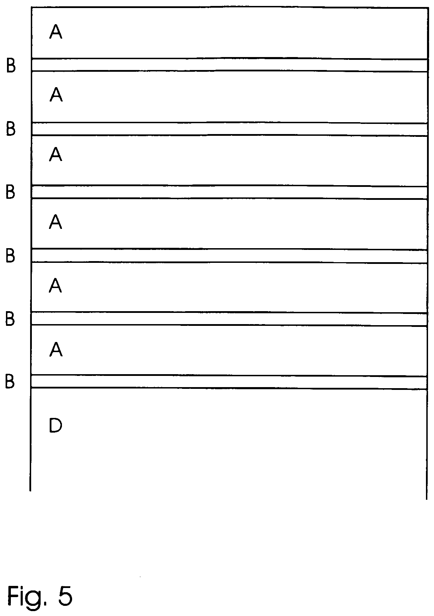

Figur 5 zeigt eine Konzeptdarstellung zur Veranschaulichung wie zwei verschiedene Materialsysteme A und B abwechselnd aufeinander liegen. Alle Schichten A und alle Schichten B sind dabei untereinander gleich dick. In diesem Beispiel beginnt die Struktur oben mit A und endet mit B. Es ist selbstverständlich auch denkbar mit B zu beginnen und mit B zu enden, oder mit A zu beginnen und mit A zu enden, oder mit A zu beginnen und mit B zu enden u.s.w..

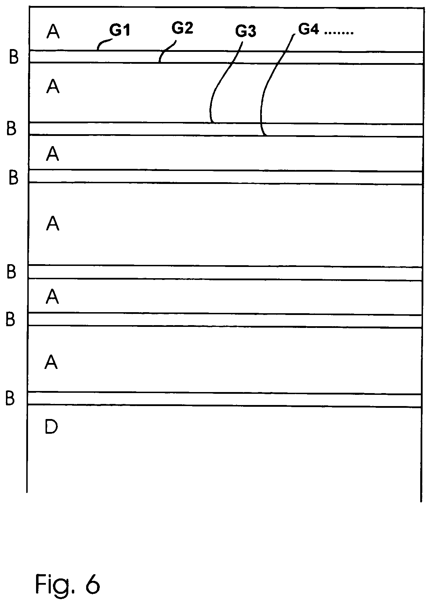

Figur 6 zeigt eine Konzeptdarstellung zur Veranschaulichung wie zwei verschiedene Materialsysteme A und B abwechselnd aufeinander liegen. Alle Schichtdicken A sind hierbei beliebig, während jedoch alle Schichten B identische Dicke aufweisen. In diesem Beispiel beginnt die Struktur oben mit A und endet mit B. Es ist selbstverständlich auch denkbar mit B zu beginnen und mit B zu enden, oder mit A zu beginnen und mit A zu enden, oder mit A zu beginnen und mit B zu enden u.s.w..

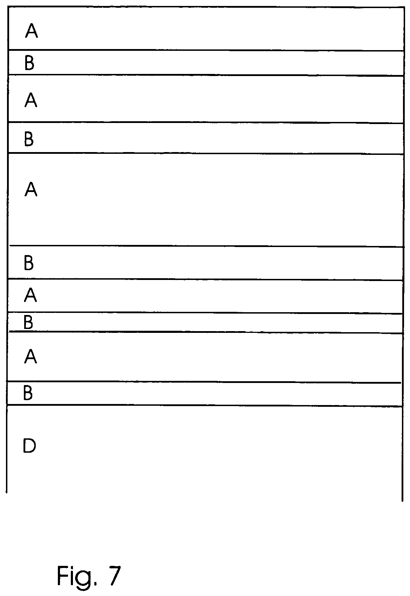

Figur 7 zeigt eine Konzeptdarstellung zur Veranschaulichung wie zwei verschiedene Materialsysteme A und B abwechselnd aufeinander liegen. Alle Schichtdicken sind hierbei beliebig.

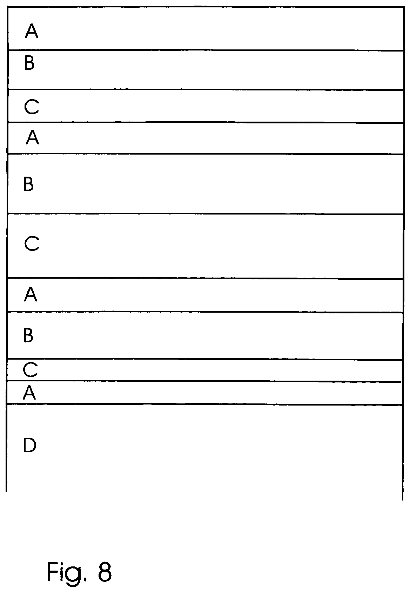

Figur 8 zeigt eine Konzeptdarstellung zur Veranschaulichung wie drei verschiedene Materialsysteme A, B und C abwechselnd aufeinander liegen. Alle Schichtdicken sind hierbei beliebig. Hierbei ist die Reihenfolge A/B/C/A/B/C/A...

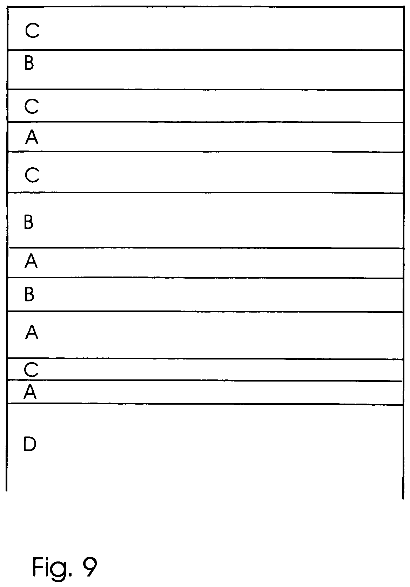

Figur 9 zeigt eine Konzeptdarstellung zur Veranschaulichung wie drei verschiedene Materialsysteme A, B und C abwechselnd aufeinander liegen. Alle Schichtdicken und die Reihenfolge sind hierbei beliebig. Es treten sinnvollerweise jedoch keine Grenzflächen A/A, B/B und C/C auf.

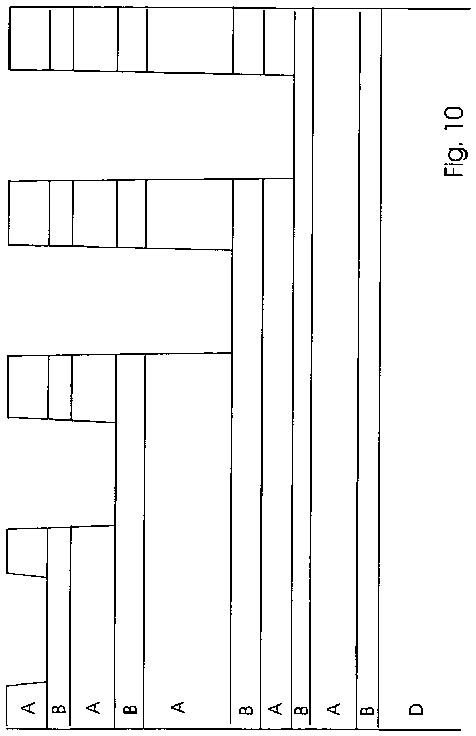

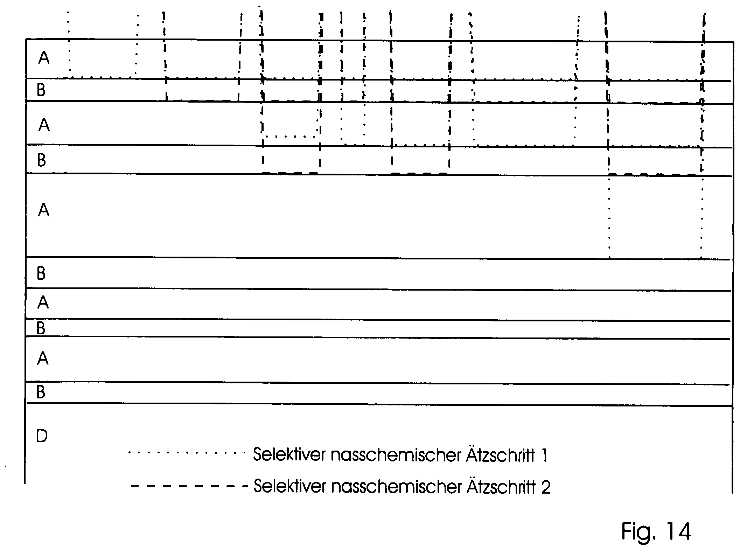

Figur 10 zeigt vier Gruben und insgesamt 4+1 verschiedene Level. Dieses Resultat kann z.B. mit dem in Fig. 2 als auch mit dem in Fig. 14 beschriebenen Verfahren realisiert werden.

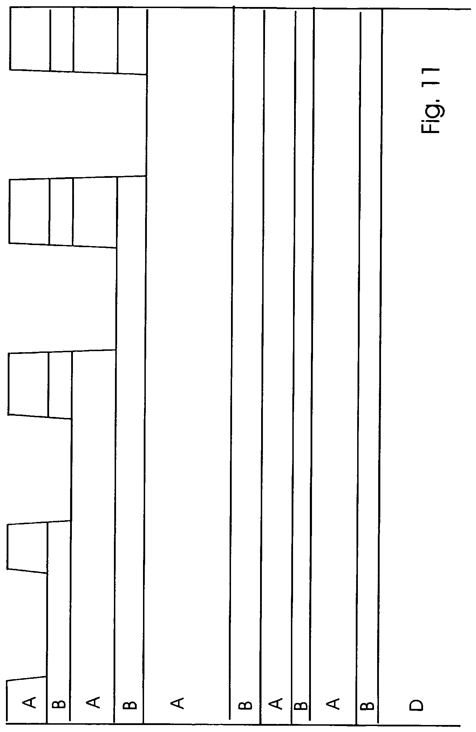

Figur 11 zeigt vier Gruben und insgesamt 4+1 verschiedene Level. Dieses Resultat kann z.B. mit dem in Fig. 14 als auch mit dem im Ausführungsbeispiel X beschriebenen Verfahren realisiert werden.

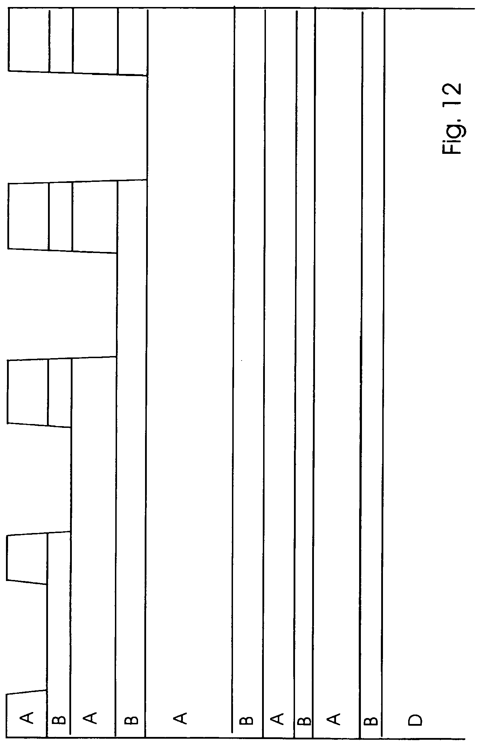

Figur 12 korrespondiert zu Figur 11 bis auf die Tatsache dass bei Bedarf auch eine Luft/B Grenzfläche realisiert werden kann.

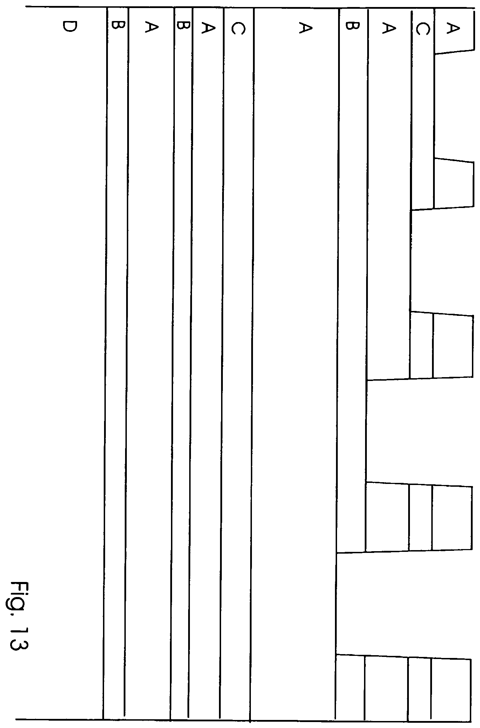

Figur 13 zeigt schematisch einen Stempel, der auf der Basis von drei verschiedenen Materialsystemen realisiert wurde.

Bei dem Ausführungsbeispiel nach Figur 14 liegen 5 Schichten A und 5 Schichten B vor, damit können M=10 verschiedene Grubentiefen im Stempel realisiert werden. Es handelt sich dabei in Figur 14 jeweils von oben nach unten betrachtet um die Grenzflächen: Luft/A, A/B, B/A, A/B, B/A, A/B, B/A, A/B, B/A, A/B. Ein elfter Level könnte realisiert werden, falls eine der verwendeten nasschemischen Ätzprozesse auch selektiv gegenüber dem Substrat D wäre.
1. Schritt: Um die oberflächennächste Grenzfläche A/B in einer Ätzgrube freizulegen wird Photolack aufgebracht, dieser partiell mit einer Photomaske belichtet und entwickelt. Dabei ist die Maske/Fotolackart so gewählt, dass das Material A an den Stellen, an denen die Grube zu ätzen ist, freigelegt wurde. Es wird nun eine selektive nasschemische Ätzlösung eingesetzt, welche das Material A ätzt, das Material B jedoch nicht. Gepunktet dargestellt.
2. Schritt: Um die nächstfolgende Grenzfläche B/A in allen oder einem Teil der bereits geätzten Gruben freizulegen wird wieder Photolack aufgebracht, dieser partiell mit einer Photomaske belichtet und entwickelt. Dabei ist die Maske/Fotolackart so gewählt, dass das Material B an den Stellen, an denen die Grube zu ätzen ist, freigelegt wurde. Es wird nun eine selektive nasschemische Ätzlösung eingesetzt, welche das Material B ätzt, das Material A jedoch nicht. Gestrichelt dargestellt.
3. Schritt: Um die nächstfolgende Grenzfläche A/B in allen oder einem Teil der bereits geätzten Gruben freizulegen wird wieder Photolack aufgebracht, dieser partiell mit einer Photomaske belichtet und entwickelt. Dabei ist die Maske/Fotolackart so gewählt, dass das Material A an den Stellen, an denen die Grube zu ätzen ist, freigelegt wurde. Es wird nun eine selektive nasschemische Ätzlösung eingesetzt, welche das Material A ätzt, das Material B jedoch nicht. Gepunktet dargestellt.

Dieses Vorgehen vermeidet teurere Trockenätzprozesse. Es werden jedoch Photomasken nasschemisch in vielen Fällen unterätzt, was beim Design berücksichtigt werden muss. Ferner sind auf Grund dieses Verfahrens für M verschiedene Level im allgemeinen auch M verschiedene Masken und M Ätzschritte erforderlich. Wie die Zahl der Schritte verringert werden kann zeigt Figur 2.

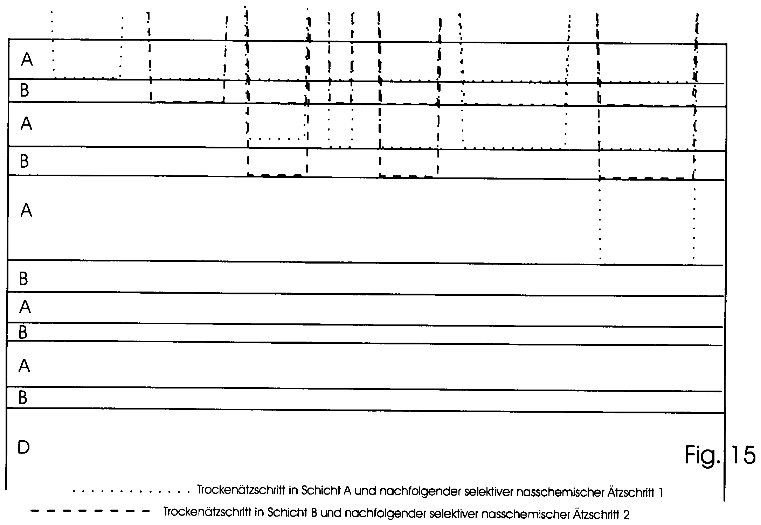

Bei dem Ausführungsbeispiel nach Figur 15 liegen 5 Schichten A und 5 Schichten B vor, damit können maximal M=10 verschiedene Grubentiefen im Stempel realisiert werden. Es handelt sich dabei in Fig. 15 jeweils von oben nach unten betrachtet um die Grenzflächen: Luft/A, A/B, B/A, A/B, B/A, A/B, B/A, A/B, B/A, A/B. Ein elfter Level könnte realisiert werden, falls eine der verwendeten nasschemischen Ätzprozesse auch selektiv gegenüber dem Substrat D wäre.
1. Schritt: Um die oberflächennächste Grenzfläche A/B in einer Ätzgrube freizulegen wird Photolack aufgebracht, dieser partiell mit einer Photomaske belichtet und entwickelt. Dabei ist die Maske/Fotolackart so gewählt, dass das Material A an den Stellen, an denen die Grube zu ätzen ist, freigelegt wurde. Es wird nun ein Trockenätzschritt in Schicht A und ein nachfolgender selektiver nasschemischer Ätzschritt eingesetzt, welche das Material A ätzt, das Material B jedoch nicht. Gepunktet dargestellt.
2. Schritt: Um die nächstfolgende Grenzfläche B/A in allen oder einem Teil der bereits geätzten Gruben freizulegen wird wieder Photolack aufgebracht, dieser partiell mit einer Photomaske belichtet und entwickelt. Dabei ist die Maske/Fotolackart so gewählt, dass das Material B an den Stellen, an denen die Grube zu ätzen ist, freigelegt wurde. Es wird nun ein Trockenätzschritt zur Ätzung der Schicht B verwendet und nachfolgend ein selektiver nasschemischer Ätzschritt eingesetzt, welche das Material B ätzt, das Material A jedoch nicht. Gestrichelt dargestellt.
3. Schritt: Um die nächstfolgende Grenzfläche A/B in allen oder einem Teil der bereits geätzten Gruben freizulegen wird wieder Photolack aufgebracht, dieser partiell mit einer Photomaske belichtet und entwickelt. Dabei ist die Maske/Fotolackart so gewählt, dass das Material A an den Stellen, an denen die Grube zu ätzen ist, freigelegt wurde. Es wird nun wieder ein Trockenätzschritt in Schicht A und ein nachfolgender selektiver nasschemischer Ätzschritt eingesetzt, welche das Material A ätzt, das Material B jedoch nicht. Gepunktet dargestellt.
4. u.s.w.

Dieses Vorgehen hat wiederum den Nachteil, dass für M verschiedene Level im allgemeinen auch M verschiedene Masken und M Ätzschritte erforderlich sind. Wie die Zahl der Schritte verringert werden kann zeigt das folgende Ausführungsbeispiel.

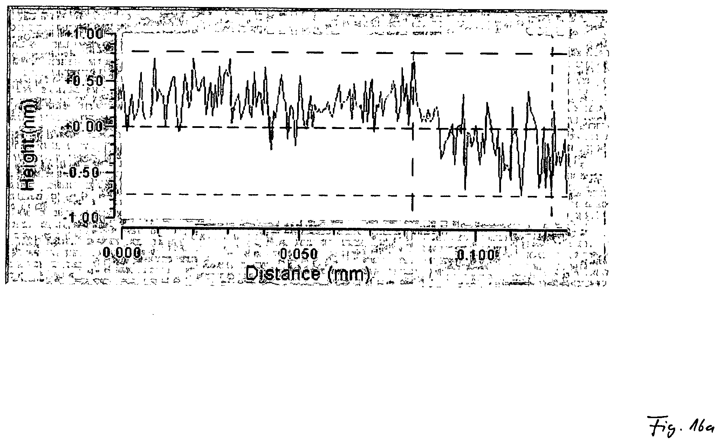

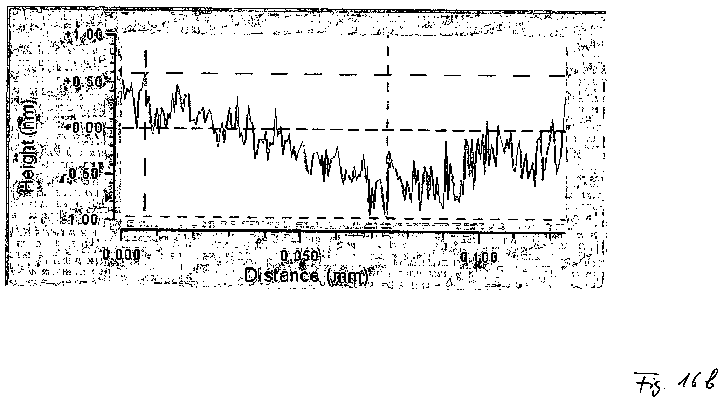

Die Figuren 16a und 16b veranschaulichen zwei Oberflächenrauhigkeitsmessungen auf dem Grubenboden an einer trockengeätzten Luft/GaAs Grenzfläche mit einem Weisslichtinterferometer. Die Oberflächenrauhigkeiten liegen dabei in der Größenordnung von ca. 1.5nm.

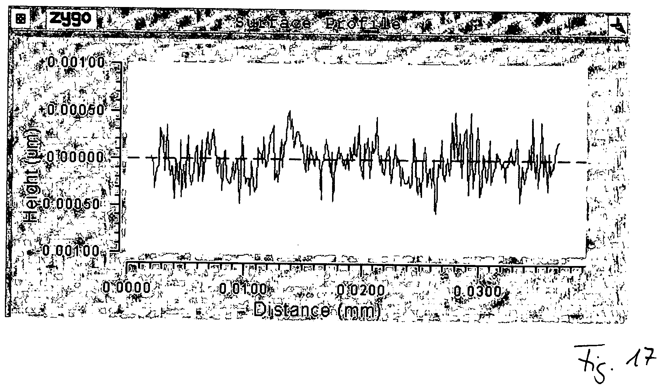

Figur 17 zeigt eine Oberflächenrauhigkeitsmessung auf dem Grubenboden an einer selektiv nass-chemisch geätzten GaInAs/InP Grenzfläche mit einem Weisslichtinterferometer. Die Oberflächenrauhigkeiten liegen dabei in der Größenordnung von ca. 0.15nm. Dieses Bild zeigt die Leistungsfähigkeit des beschriebenen Verfahrens

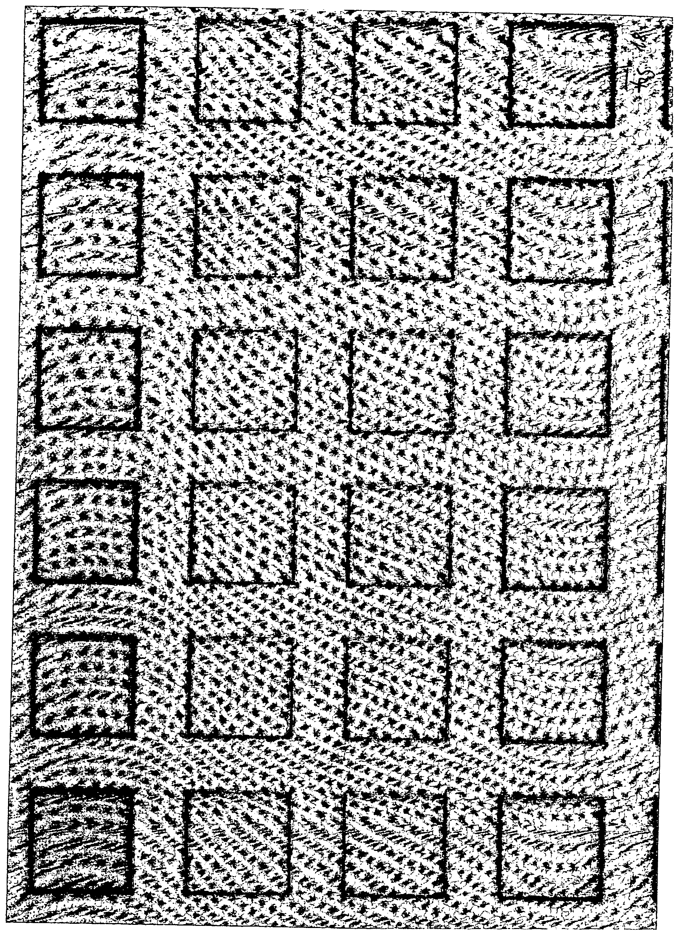

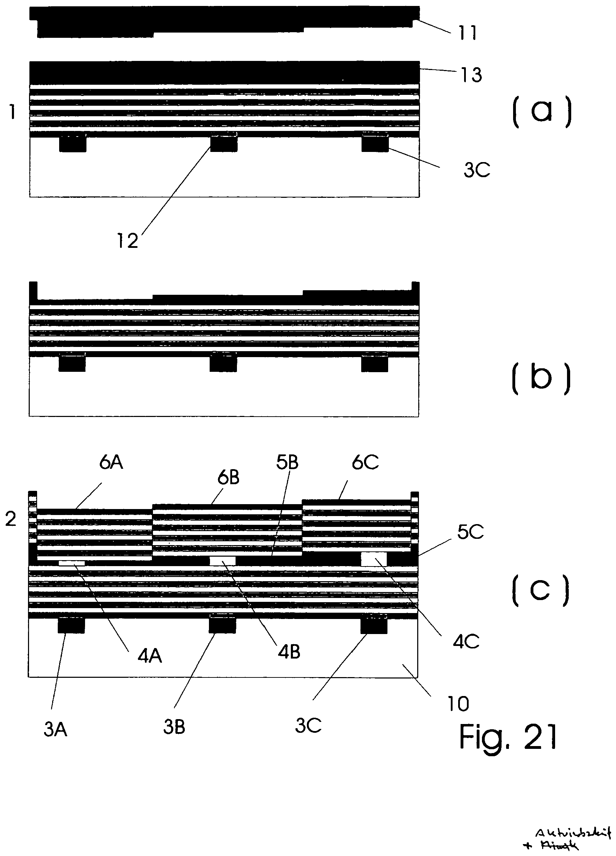

Figur 18 zeigt eine lichtmikroskopische Aufnahme eines Stempels, mit 8x8=64 verschiedenen Grubentiefen. Selbstverständlich können die Stempel lateral beliebige Muster aufweisen. Diese Abbildung ist lediglich als Beispiel zu verstehen. Eine derartige Anordnung wäre z.B. für das in Figur 21 veranschaulichte Sensorarray verwendbar.

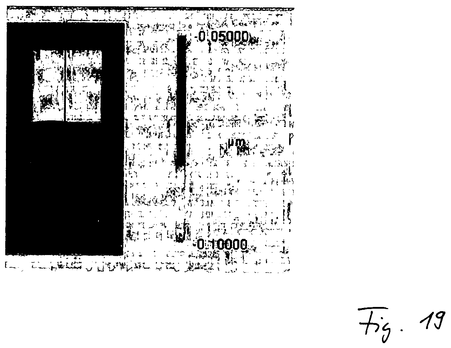

Figur 19 zeigt eine Messung eines Stempel-Ausschnittes mit einem Weisslichtinterferometer, wobei die zwei Gruben unterschiedliche Tiefen aufweisen. Die Tiefe ist dabei in verschiedene Graustufen umgesetzt.

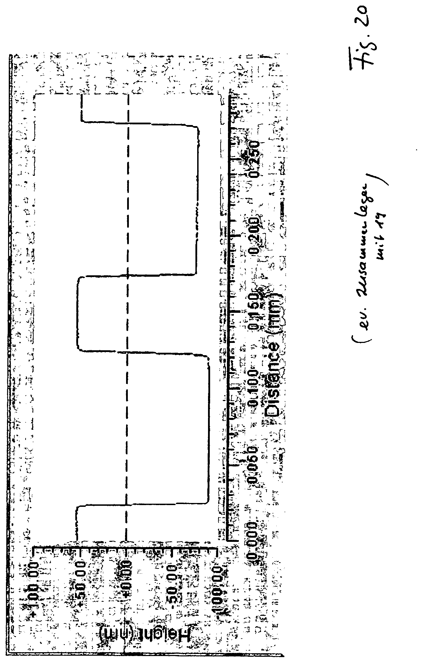

Figur 20 zeigt eine Messung mit einem Oberflächenprofilometer an zwei verschiedenen Gruben.

In Figur 21a ist gezeigt, wie der Nano-Imprint-Stempel 11 eingesetzt wird. Auf ein CCD Array (oder ein Photodetektor Array oder einen optical ASIC mit Photodioden) wird eine gitterartige Struktur aus der Elektrode 7 und einem Buffer-Element 12 definiert. Darauf wird der untere DBR Spiegel 1 abgeschieden und darauf die organische Schicht abgeschieden (Fig. 21a), welche nachfolgend strukturiert werden soll.

In Figur 21b wurde mit dem Stempel 11 mit dem Nano-Imprint strukturiert und danach z.B. mit UV Licht oder thermisch ausgehärtet. Danach wird der Stempel abgezogen.

Durch die Deposition des oberen DBR Spiegels 2 entsteht nun ein vollständiger Filter (Figur 21c). Es folgt nun die Deposition der oberen Kontakte 6 und die partielle Entfernung des organischen Materials. Dadurch entstehen die Luftkavitäten 4A, 4B, 4C. Mit dem vorliegenden Verfahren werden also die Halteblöcke geprägt.

In Figur 21 nicht dargestellt ist die Tatsache, dass sich die DBR Spiegel in ihrer Zusammensetzung und/oder Schichtdicke nach einer bestimmten Anzahl von Pixeln (z.B. 30) ändern.

Eine mögliche Ausführungsart stellen Fabry-Perot-Filter dar, deren vertikaler Resonator aus mindestens 2 DBR Spiegeln besteht. Der DBR Spiegel 1 weist jeweils mindestens ein Schichtpaar auf, welche aus zwei Schichten, einer Schicht (1a) und einer Schicht (1b) besteht. Die Schichtpaarzahl eines Spiegels ist dabei ganz- oder halbzahlig, Der DBR Spiegel 2 weist jeweils mindestens ein Schichtpaar auf, welche aus zwei Schichten, einer Schicht (2a) und einer Schicht (2b) besteht. Die Schichtpaarzahl eines Spiegels ist dabei ganz- oder halbzahlig, Der Aufbau der Filter und der DBR Spiegel ist Stand der Technik. Jedem Filter ist nun mindestens eine Photodiode (Detektor) 3 zugeordnet. Im Rahmen dieser Beschreibung wird daher stets von einem Filter/Detektorpaar gesprochen. (Darunter soll jedoch auch der Fall verstanden werden, dass einem Filter zwei Detektoren, oder einem Detektor auch zwei Filter zugeordnet sein können. Jedoch wird die Zuordnung eines Filters zu einem Detektor als die sinnvollste Lösung angesehen).

Die vertikale Schichtdicke des Kavitätsmaterial (Kavitätslänge) bestimmt dabei die Zentralwellenlänge des transmittierten Spektralbereichs. Ferner bestimmt die Anzahl an Schichtpaaren pro Spiegel, den Brechungsindexkontrast im Wesentlichen den spektralen Bereich höchster Reflektivität (Stopbandbreite). Der spektrale Bereich der anwendungstechnisch für die Filterfunktion eingesetzt wird (Detektions-Wellenlängenbereich) durch diese Stopbandbreite bestimmt. Durch eine Variation der vertikalen Schichtdicke der Luftkavität 4 von Filter zu Filter wird die Zentralwellenlänge von Filter zu Filter variiert. Erfindungsgemäß werden nun mindestens zwei mikromechanisch abstimmbare Filter/Detektor-Paare als Array in lateraler Richtung (x,y-Richtung) kombiniert. In Abb. 21 ist dies in x-Richtung für 3 Paare dargestellt. Wenn jedoch die Schichtdicke der Halteblöcke/unaktuierte Luft-Kavität in vertikaler Richtung von Element zu Element variiert, selektieren alle drei dargestellten Filterdetektor-Paare unterschiedliche Wellenlängen. In allen Fällen erreichen unterschiedliche, durch das Design des Stempels vorgewählte Wellenlängen die Photodioden.

Dadurch kann das folgende Wirkprinzip erreicht werden: von links nach rechts gesehen selektiert das erste Filter/Detektor-Pixel (A) die Wellenlänge lambdaA, das zweite Filter/Detektor-Pixel (B) die Wellenlänge lambdaB und das dritte Filter/Detektor-Pixel (C) die Wellenlänge lambdaC. Dies sind die Wellenlängen, welche von den Detektor-Elementen 3 detektiert werden. Legt man zwischen die Elektroden 6A und 7 eine Spannung, so werden die Spiegel oberhalb der Luftspaltkavität 4A aktuiert und damit die Wellenlänge variiert, welche den Filter A transmittiert und den Detektor 1A erreicht. Da die Kontakte 6A, 6B und 6C keine Verbindung untereinander haben, läßt sich die Abstimmung der Filter/Detektor-Paare A, B, C unabhängig voneinander vornehmen, indem an jedes Paar genau die Aktuationsspannung angelegt wird, welche für die gewünschte Wellenlängenselektion/Wellenlängenabstimmung gerade erforderlich ist. Die Aktuation wird hierbei elektrostatisch vorgenommen. Alternativ ist auch eine thermische Aktuation der einzelnen Filter denkbar.

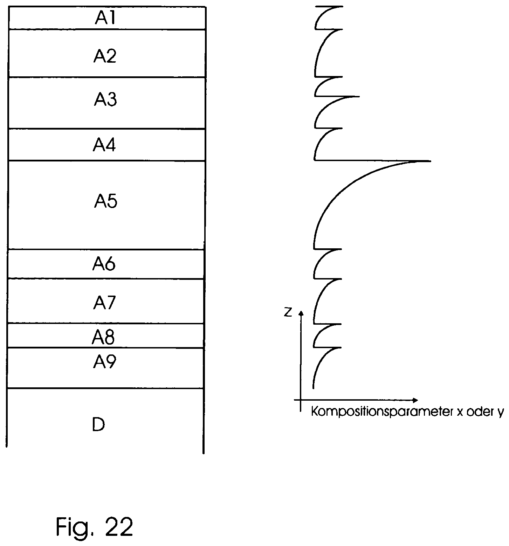

Figur 22 zeigt eine Konzeptdarstellung zur Veranschaulichung wie auf der Basis eines Materials z.B. AlₓGa₁₋ₓAs oder Ga_{y}In_{1-y}As Kompositionsverläufe (Legierungsverläufe) durch Variation der Kompositionsparameter x oder y realisiert werden können, um abrupte Grenzflächen zu erzeugen, welche jeweils einen Ätzstop beim nass-chemischen Ätzen bewirken können.

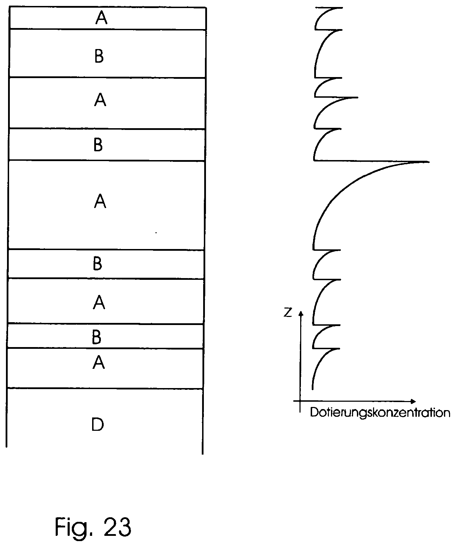

Figur 23 veranschaulicht einen Dotierungsverlauf innerhalb eines Materials wie z.B. GaAs. In der Abbildung ändert sich die Dotierungskonzentration in vertikaler Richtung immer wieder zwischen einer niedrigen und einer hohen Dotierungskonzentration, wobei abrupte Wechsel erzielt werden (Grenzflächen), welche jeweils einen Ätzstop beim nass-chemischen Ätzen bewirken können.

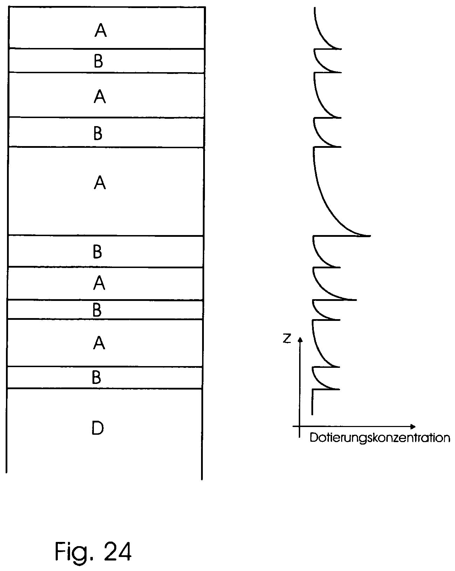

Gemäß Figur 24 ändert sich die Dotierungskonzentration in vertikaler Richtung (z-Richtung) immer wieder zwischen einer niedrigen und einer hohen Dotierungskonzentration, wobei abrupte Wechsel erzielt werden (Grenzflächen), welche jeweils einen Ätzstop beim nass-chemischen Ätzen bewirken können.

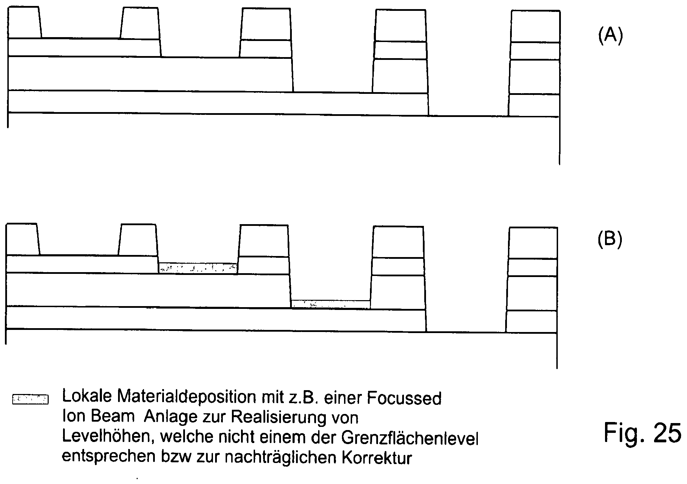

Figur 25 zeigt veranschaulicht einen Aufbau (a) vor Anwendung einer lokalen Deposition (b) nach Ausführung der lokalen Deposition. Die Deposition erfolgt dabei bevorzugt mit einem maskenlosen Verfahren (z.B. Focussed Ion Beam). Auch hierbei ist eine Definition von Levelhöhen außerhalb des durch die Position der Heterogrenzflächen vorgegebenen Levelhöhen möglich oder eine Nachkorrektur von einzelnen Levelhöhen.

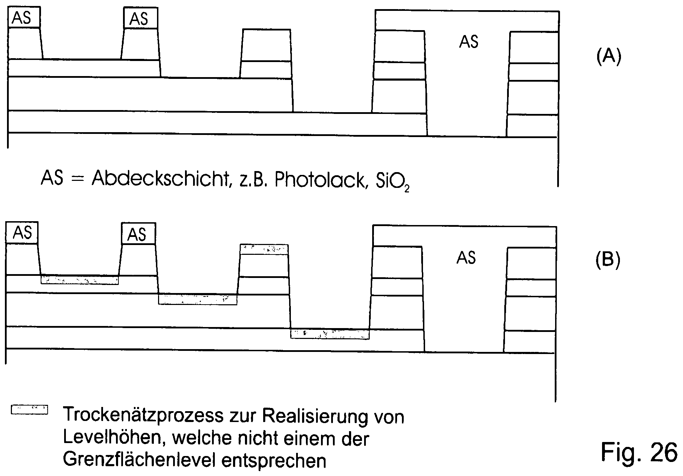

Fig. 26 veranschaulicht (a) eine Teilmaskierung mit einer Abdeckschicht AS. In (b) wurde den nicht abgedeckten Stempelbereichen mit Hilfe eines Trockenätzschrittes die Levelhöhe verringert. Dies kann unter anderem folgenden Hintergrund haben: es ist eine Definition von Levelhöhen außerhalb des durch die Position der Heterogrenzflächen vorgegebenen Levelhöhen möglich oder eine Nachkorrektur von einzelnen Levelhöhen. Entsprechend kann (hier nicht dargestellt) auch eine Deposition erfolgen, wobei sich dann die Levelhöhe erhöht. Der Hintergrund dieser Maßnahme entspricht dabei dem von Fig. 26.

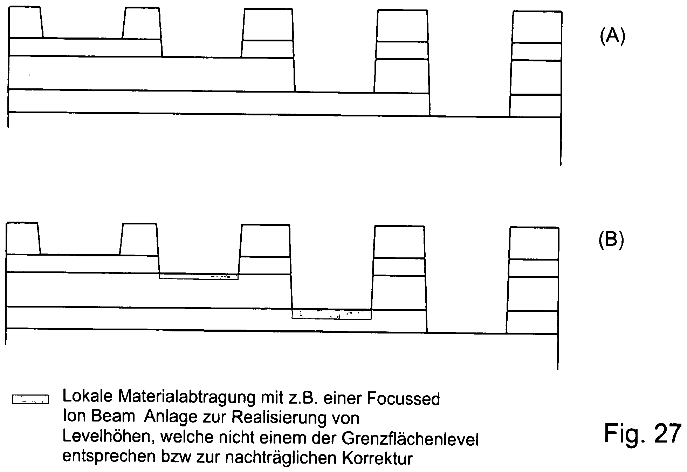

Figur 27 veranschaulicht einen Aufbau (a) vor Anwendung eines lokalen Ätzens (b) nach Ausführung der Ätzung. Die Ätzung erfolgt dabei bevorzugt mit einem maskenlosen Verfahren (z.B. Focussed Ion Beam). Auch hierbei ist eine Definition von Levelhöhen außerhalb der durch die Position der Heterogrenzflächen vorgegebenen Levelhöhen möglich oder eine Nachkorrektur von einzelnen Levelhöhen.

Es wird ein Trockenätzprozess gewählt, welcher sowohl die Schichen A als auch die Schichten B zu ätzen vermag. Dadurch kann in einem Stück bis kurz vor die gewünschte Grenzfläche (A/B oder B/A) mit dem Trockenätzen vorgedrungen werden. Wird dabei im Material A gestoppt, so kommt eine nass-chemische Ätzlösung zum Einsatz welche A selektiv gegenüber B ätzt. Nun ist die Grenzfläche A/B freigelegt. Wird jedoch dabei im Material B gestoppt, so kommt eine nass-chemische Ätzlösung zum Einsatz welche B selektiv gegenüber A ätzt. Nun ist die Grenzfläche B/A freigelegt. Mit M Schritten können damit maximal (2^{M}+1) verschiedene Level erzeugt werden

Für die Herstellung eines Mesa-Arrays, bei dem sich die einzelnen Mesa in ihrer Höhe nur im Bereich etwa eines Nanometers unterscheiden ist entweder mit einer einzigen Multischichtstruktur mit extrem geringen Schichtdicken möglich (z.B mit einer Kombination von mehreren Stempeln bei denen der erste Stempel beispielsweise eine Levelhöhe von 200nm, 204nm, 208nm, ... realisiert, der zweite Stempel eine Levelhöhe von 201nm, 205nm, 209nm, ... realisiert, der dritte Stempel eine Levelhöhe von 202nm, 206nm, 210nm, ... realisiert und der vierte Stempel eine Levelhöhe von 203nm, 207nm, 211nm, ... realisiert. In einer Realisierung mit einer modifizierten Tintenstrahl-Technologie aufgebrachten gezielt platzierten organischen Print-Materialien können diese Strukturen sogar ineinander geprintet werden.

Für die Herstellung eines Mesa-Arrays, bei dem sich die einzelnen Mesa in ihrer Höhe nur im Bereich etwa eines Nanometers unterscheiden ist ferner auch eine Kombination verschiedener Techniken denkbar. Beispielsweise zunächst eine hochpräzise Grundrasterung mit einzigen Multischichtstruktur vorgenommen werden, welche z.B. Levelhöhen von 101nm, 105nm, 109nm, ... realisiert. Darauf aufbauend werden Trockenätzprozesse unterschiedlicher Dauer angewendet um z.B. noch die gewünschten Zwischenwerte (102nm, 103nm, 104nm, 106nm, 107nm, 108nm, 110nm, 111nm, 112nm,...) zu erreichen.

Eine weitere sehr sinnvolle Modifikation ist in der Ausführung aller Trockenätzschritte zu sehen. Erst nachdem alles Gruben-Strukturen bis kurz vor eine Grenzfläche trocken vorgeätzt wurden, wird in einem einzigen nasschemischen Schritt alle dünnen Restschicht in einem einzigen Schritt geätzt. Dieses Verfahren wird als besonders effizient angesehen und ist ebenfalls in Fig. 2 illustriert.

Möchte man auch hierbei alle Grenzflächen nutzen werden sinnvollerweise zwei selektive nass-chemische Ätzschritte angewendet. Der erste ätzt dabei z.B. die Reste der Schichten A und der zweite die Reste der Schichten B.

## Patentansprüche

1. Nano-Imprint Stempel mit:
- einem Stempelkorpus (K) der durch lokalen Materialabtrag aus einem Stempelrohling gefertigt ist und eine Stempelstirnstruktur bildet, wobei diese Stempel Stirnstruktur in Richtung einer Stempelsetzachse (X) in ein Umformsubstrat einpressbar ist, zur Generierung eines zur Stempelstirnstruktur komplementären Abdrucks.
- wobei die Stempelstirnstruktur mehrere Setzflächen (S1, S2,...) trägt, die im wesentlichen quer zur Stempelsetzachse (X) ausgerichtet sind, und zumindest einige dieser Setzflächen (S1,S2,...) in Richtung der Stempelsetzachse (X) betrachtet unterschiedliche Levelpositionen (L1, L2...) einnehmen,
- wobei der Stempelrohling als Schichtstruktur aufgebaut ist, und mehrere Schichtgrenzen (G1, G2, G3) beinhaltet, und
- die Schichtstruktur derart gestaltet ist, dass die Positionen der Schichtgrenzen (G1, G2, G3) den Levelpositionen (L1, L2...) entsprechen.
- **dadurch gekennzeichnet, dass** die Schichtgrenzen durch eine markante Dotierungsänderung gebildet sind.

2. Nano-Imprint Stempel nach Anspruch 1, **dadurch gekennzeichnet, dass** dieser zur Herstellung extrem präziser dreidimensionaler Strukturen mit einer vertikalen Auflösung bis hinunter zu 0,1 nm verwendet wird.

3. Nano-Imprint Stempel nach wenigstens einem der Ansprüche 1 bis 2, **dadurch gekennzeichnet, dass** bei der Fertigung des Stempelkorpus in diesem mindestens zwei dielektrische Schichten gebildet werden.

## Claims

1. Nano-Imprint stamp comprising:
- a punch body (K) which is produced by local removal of material from a stamp-blank and which forms a punch end structure, wherein said punch front end structure in the direction of a stamp set axis (X) may be pressed into a substrate, for generating an imprint which is complementary to the stamp face structure,
- the stamp face structure is carrying a plurality of setting surfaces (S1, S2, ...), which are aligned substantially transversely to the stamp set axis (X), and at least some of these set surfaces (S1, S2, ...) in the direction of the stamp set axis (X) provides different level positions (L1, L2 ...).
- the stamp blank is constructed as a layer structure which includes a plurality of layer boundaries (G1, G2, G3), and
the layer structure is designed such that the positions of the layer boundaries (G1, G2, G3) correspond to the level positions (L1, L2, ...).
- **characterized in that** the layer boundaries are formed by a significant dotation gradient.

2. Nano-Imprint stamp according to claim 1, **characterized in that** same is used for the production of extremely precise three-dimensional structures with a vertical resolution down to 0.1 nm.

3. Nano-Imprint stamp according to at least one of claims 1 to 2, **characterized in that** upon the generation of the stamp body at least two dielectric layers are formed within same.

## Revendications

1. Tampon d'impression nanometrique avec:
- un corps de poinçon (K) qui est produit par enlèvement local de matière d'une ébauche de tampon et forme une structure d'extrémité de poinçon, ladite structure avant de poinçon dans la direction d'un axe de jeu de tampon (X) pouvant être pressée dans un substrat de formage, pour générer une empreinte de structure de face de tampon correspondant,
- la structure de face de tampon comporte une pluralité de surfaces de réglage (S1, S2, ...) qui sont alignées sensiblement transversalement par rapport à l'axe de jeu de tampons (X), et au moins certaines de ces surfaces de jeu (S1, S2, ...) dans la direction de l'axe de jeu de tampons (X) considère différentes positions de niveau (L1, L2 ...),
- l'ébauche de tampon est construite comme une structure de couche et une pluralité de limites de couche (G1, G2, G3) comprend et
la structure des couches est conçue de telle sorte que les positions des limites des couches (G1, G2, G3) correspondent aux positions de niveau (L1, L2, ...),
- **caractérisé en ce que** les limites de couche sont formées par un gradient de dotation significant.

2. Tampon d'impression nanometrique selon la revendication 1, **caractérisé en ce qu'**il est utilisé pour la fabrication de structures tridimensionnelles extrêmement précises avec une résolution verticale allant jusqu'à 0,1 nm.

3. Tampon d'impression nanometrique selon au moins l'une des revendications 1 à 2, **caractérisé en ce que** lors de la génération du corps de tampon, au moins deux couches diélectriques sont formées à l'intérieur de celui-ci.
